# EUROPÄISCHE PATENTSCHRIFT

(11) **EP 0 370 211 B1**
(45) Veröffentlichungstag und Bekanntmachung des Hinweises auf die Patenterteilung: **23.07.1997**
(21) Anmeldenummer: 89118361.8
(22) Anmeldetag: 04.10.1989
(51) Int. Cl.: C23C 14/34, B32B 15/01, C22F 1/04

(54) **Aluminium-Verbundplatte und daraus hergestellte Targets**
Laminated aluminium plate and targets produced therefrom
Plaque stratifiée en aluminium et cible obtenue en utilisant cette plaque

(30) Priorität: 25.11.1988 DE 3839775
(43) Veröffentlichungstag der Anmeldung: 30.05.1990
(73) Patentinhaber: VAW Aluminium AG, D-53117 Bonn (DE); BALZERS AKTIENGESELLSCHAFT, 9496 Balzers (LI)
(72) Erfinder: Dumont, Christian Dr., D-5303 Bornheim 1 (DE); Schmitz, Norbert, D-5350 Euskirchen (DE); Quaderer, Hans, FL-9494 Schaan (LI)
(74) Vertreter: Müller-Wolff, Thomas, Dipl.-Ing.

(56) Entgegenhaltungen:
- EP-A- 0 024 355
- WO-A-87/02712
- DE-A- 3 030 329
- DE-C- 749 695
- US-A- 3 878 871
- JOURNAL OF APPLIED PHYSICS, Band 51, Nr. 1, Januar 1980, Seiten 718-725, American Institute of Physics, New York, US; S. MANIV et al.: "Oxidation on an aluminum magnetron sputtering target in Ar/O2 mixtures"
- ALUMINIUM-TASCHENBUCH, W. HUFNAGEL, 14. Auflage, 1983, Seiten 56,253-257, Aluminium Verlag, Düsseldorf, DE
- METALS HANDBOOK, PROPERTIES AND SELECTION : NON FERROUS ALLOYS AND PURE METALS, 9. Auflage, Band 2, 1979, Seiten 113-123, American Society for Metals, Ohio, US
- ALUMINIUM-TASCHENBUCH, 14. Auflage, Seiten 31,712-713
- COATING MATERIALS NEWS, Heft 1/94
- VDI LEXIKON DER WERKSTOFFTECHNIK, Seite 962

## Beschreibung

Die Erfindung betrifft eine Aluminium-Verbundplatte, die als Target für die Beschichtung mittels Kathodenzerstäubung verwendbar ist, bestehend aus einer Nutzschicht aus Reinaluminium (Al ≥ 99,99) oder aus einer auf Reinaluminiumbasis (Al ≥ 99,99) erschmolzenen binären oder ternären Legierung und einer Trägerschicht.

Im Dokument DE-C-749 695 wird ein Verfahren zum Aufbringen eines Schutzüberzuges aus Reinaluminium oder einer korrosionsbeständigen Aluminiumlegierung auf aushärtbare Aluminiumlegierungen durch abwechselnde Kaltverformung, insbesondere durch Walzen, und darauffolgendes Ausglühen beschrieben.

Bei der Kathodenzerstäubung, die zu den physikalischen Beschichtungsmethoden zählt, wird das zu zerstäubende Material, das Target mit energiereichen Gasionen, die im elektrischen Feld beschleunigt werden, "beschossen". Dadurch werden Oberflächenatome aus dem Target herausgeschlagen, die sich auf der zu beschichtenden Fläche niederschlagen und eine Schicht bilden. Durch zusätzliches Anlegen eines Magnetfeldes am Target wird das Penning Prinzip ausgenutzt, die Abstäubraten werden dadurch bedeutend höher. Man spricht von Magnetron-Zerstäubung. Ein geringer Anteil der eingebrachten Energie wird bei diesem Prozess in kinetische Energie, der größere Anteil wird in Wärme umgewandet. Zum Abtransport dieser Energie müssen die Targets von der Rückseite intensiv gekühlt werden.
Materialien wie Al und Al-Legierungen werden durch die restliche Erwärmung in ihrer Stabilität beeinträchtigt.
Um trotzdem mit hohen Energieleistungen zerstäuben zu können, werden Targets mit Rückplatten versehen, die eine hohe mech. Stabilität und gute Wärmeleitfähigkeit haben, damit die Erwärmung des Targets und seine Durchbiegung möglichst gering gehalten werden.
Nach dem Stand der Technik besteht die Rückplatte bei Aluminium und Aluminiumlegierungen aus Kupfer. Die Verbindung der beiden Metalle erfolgt normalerweise durch Kleben, Löten oder Sprengplattieren. Walzplattieren ist wegen der erforderlichen Wanddicke des Kupfers von mehr als 3 mm nicht möglich.

Aufgabe der vorliegenden Erfindung ist es, eine Aluminium-Verbundplatte für die Sputter-Technik oder für ähnliche Anwendungsfälle zu entwickeln, die in einem einfachen und preiswerten Verfahren herstellbar ist, wobei die Härte der Trägerschicht HB ≧ 70 beträgt und für die Herstellung von Targets für die Sputtertechnik geeignet ist. Die Aufgabe wird erfindungsgemäß durch die in den Patentansprüchen angegebenen Merkmale gelöst.

Der Erfindungsgedanke besteht im wesentlichen darin, daß die Aluminium-Verbundplatte aus einer Trägerschicht aus einer aushärtbaren Legierung - vorzugsweise vom Typ AlMgSi - und einer Nutzschicht bestehend aus Reinaluminium (Al ≧ 99,99) oder aus einer auf Reinaluminiumbasis (Al ≧ 99,99) erschmolzenen binären oder ternären Legierung besteht, wobei die Schichtdicken 10 bis 20 mm für die Nutzschicht und 3 bis 10 mm für die Trägerschicht betragen.

Der Gesamtaufbau wird vorzugsweise durch Walzplattieren bei Temperaturen zwischen 350 bis 450 °C hergestellt. Der Anteil des Trägerwerkstoffs beträgt vorzugsweise 20 bis 35 % der Gesamtdicke. Nach dem Warmwalzen mit einem Walzgrad von mind. 20 % wird die Verbundplatte bei Temperaturen zwischen 450 und 540 °C Metalltemperatur weniger als 30 Minuten lösungsgeglüht, vorzugsweise weniger als 15 Minuten, in Wasser abgeschreckt und anschließend einer Warmauslagerung von 2 bis 16 Stunden bei 160 bis 180 °C unterworfen.

Mit dieser Behandlung wird einerseits die Festigkeit der Trägerschicht und andererseits das Gefüge der Nutzschicht verbessert. In dieser beträgt der mittlere Korndurchmesser < 4 mm bei einer Streckung S < 4. In der bevorzugten Ausführungsform besteht die Trägerschicht aus einer Legierung vom Typ AlMgSi, die nach einer Lösungsglühung bei 485 bis 495 °C und anschließender Warmauslagerung eine Härte HB > 84 aufweist, und einer Nutzschicht aus Reinaluminium (Al ≥ 99,99 oder aus einer auf Reinaluminiumbasis (Al ≥ 99,99) erschmolzenen binären oder ternären Legierung, enthaltend wenigstens eines der Legierungselemente Si, Cu, Ti, wobei der Korndurchmesser weniger als 2 mm und die Streckung S < 2 beträgt. Die Gleichmäßigkeit und Feinkörnigkeit des Gefüges ist besonders günstig für den gleichmäßigen Abtrag beim Sputtern.

Wie eingangs erläutert, wird beim Sputtern die Nutzschicht mit energiereichen Gasionen beschossen. Um einen gleichmäßigen Abtrag und damit eine möglichst lange Nutzungsdauer der Nutzschicht zu erreichen, muß diese möglichst gleichförmig und homogen ausgebildet sein. Durch die erfindungsgemäße Walzplattierung beim Anteil Trägerwerkstoff von 20 bis 35 % der Gesamtdicke wird dieses walztechnisch am besten erreicht bei einem Walzgrad von mindestens 20 % im Temperaturbereich zwischen 350 bis 450 °C.

Die Lösungsglühung bei 450 bis 550 °C Metalltemperatur für weniger als 30 Minuten ist entscheidend für die Erzielung eines geeigneten Korns in der Nutzschicht. Angestrebt wird ein quasiglobulitisches Feinkorn mit einer Streckung S < 2. Erfindungsgemäß wurde ein derartiges Korn nach dem Lösungsglühen erreicht, wobei der mittlere Korndurchmesser unterhalb von 1 mm lag, gemessen nach Dederichs und Kostron. Bei dem erfindungsgemäßen Verfahren kommt es genau auf die Einhaltung der Glühdauer an. Bei Glühzeiten von mehr als 30 Minuten erhält man ein Grobkorn, das beim Abtrag der Nutzschicht zu Unregelmäßigkeiten in der Zerstäubungsrate führt. Diese Unregelmäßigkeiten führen zu ungleichmäßigem Auftrag auf dem Substrat.

Bei Glühzeiten von weniger als einer Minute gehen allerdings zu geringe Anteile von aushärtenden aluminiumhaltigen Phasen in Lösung, so daß nach der Warmaushärtung die Härte der Trägerschicht eine Härte von 70 HB nicht erreicht und damit die Verbundplatte eine zu geringe Standfestigkeit für die Verwendung zur Beschichtung mittels Kathodenzerstäubung aufweist.

Im folgenden wird die Erfindung anhand eines Ausführungsbeispieles näher erläutert. Es zeigen:

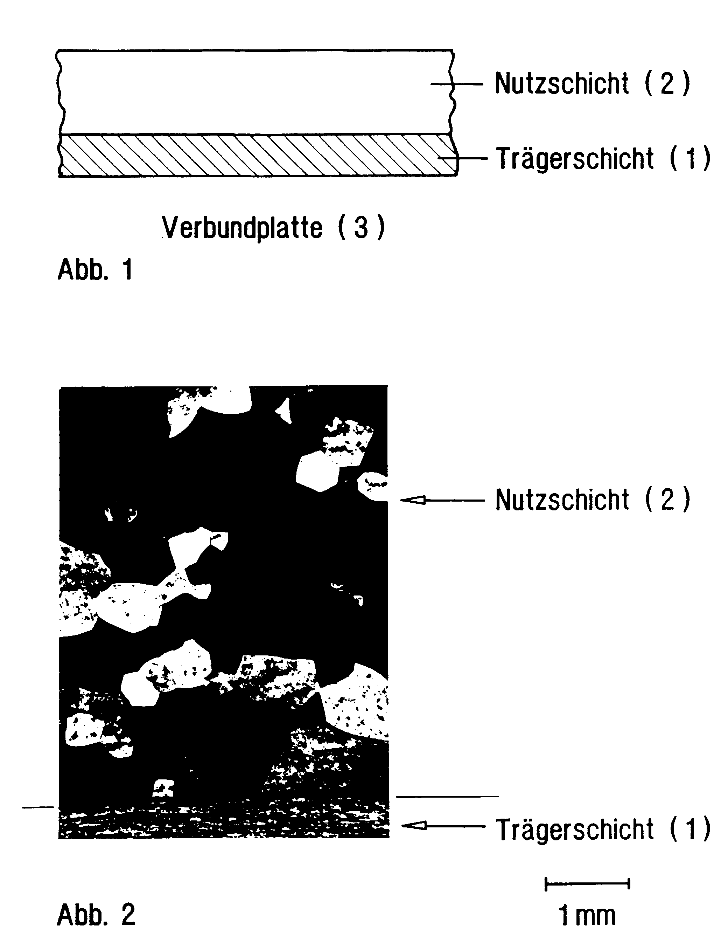

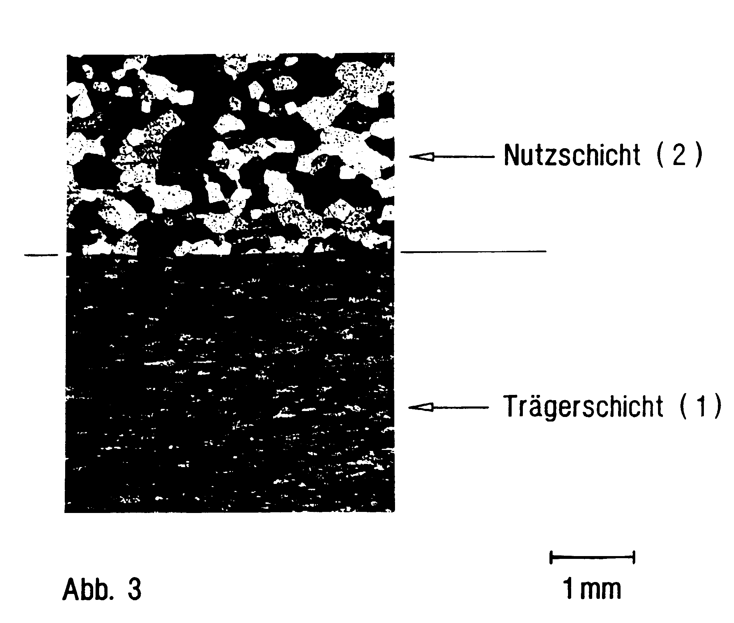

- Fig. 1 =: Querschnitt durch eine erfindungsgemäße Aluminiumverbundplatte,
- Fig. 2 u. 3 =: Vergrößerungen im Maßstab 20:1 von Querschliffen durch erfindungsgemäß hergestellte Aluminiumverbundplatten.

Eine nach dem angemeldeten Plattierverfahren hergestellte Verbundplatte, bestehend aus einer 14 mm dicken Nutzschicht 2 aus Al99,9999 + 1 % Si und einer 5 mm dicken Trägerschicht 1 aus AlMgSi1 wurde in Abschnitte A, B geteilt und dann wie folgt behandelt:

| Behandlung | Lösungsglühzeit im Salzbad | Lösungsglühtemperatur |
|---|---|---|
| A | 20 min. | 530 °C |
| B | 5 min. | 490 °C |

Anschließend wurden die Platten im kalten Wasser abgeschreckt und 16 Stunden bei 160 °C warmausgelagert.

Die Messungen der Brinellhärte an den Trägerschichten und die Messung der Korngröße im Längsschliff der Nutzschichten ergab folgende Werte:

| Behandlung | Kornquerschnitt in µm² | mittlerer Korndurchmesser in µm | Streckung | HB | Abb. |
|---|---|---|---|---|---|
| A | 2,37.10⁵-1,78.10⁶ | 549-1505 | 1 | 115 | 2 |
| B | 1,78.10⁴-7,50.10⁴ | 151-309 | 1 | 95 | 3 |

Aus dem vorstehenden Vergleich zweier erfindungsgemäß hergestellter Aluminiumverbundplatten ist ersichtlich, daß die gewünschte quasi globulitische Struktur mit einer Streckung S = 1 unter den erfindungsgemäßen Bedingungen erreicht wird.

## Patentansprüche

1. Aluminium-Verbundplatte, die als Target für die Beschichtung mittels Kathodenzerstäubung verwendbar ist, bestehend aus einer Nutzschicht aus Reinaluminium (Al 99,99 Gew.-%) oder aus einer auf Reinaluminiumbasis (Al ≥ 99,99 Gew.-%) erschmolzenen binären oder ternären Legierung und einer Trägerschicht aus einer Aluminiumlegierung,
dadurch gekennzeichnet,
daß die Trägerschicht aus einer aushärtbaren Aluminiumlegierung vom Typ AlMgSi mit einer Mindesthärte HB > 70 besteht und auf der Trägerschicht eine Nutzschicht walzplattiert ist, die ein gleichmäßiges, feinkörniges Gefüge aus quasiglobulithischen Feinkörnern aufweist, dessen mittlerer Korndurchmesser < 2 mm und dessen Streckung S < 2 beträgt.

2. Aluminium-Verbundplatte nach Anspruch 1,
dadurch gekennzeichnet,
daß die Nutzschicht eine Schichtdicke von 10 bis 20 mm und die Trägerschicht eine Schichtdecke von 3 bis 10 mm aufweist.

3. Verfahren zur Herstellung einer Aluminium-Verbundplatte, die als Target für die Beschichtung mittels Kathodenzerstäubung verwendbar ist, bestehend aus einer Nutzschicht aus Reinaluminium (Al ≥ 99,99 Gew.-%) oder aus einer auf Reinaluminiumbasis (Al ≥ 99,99 Gew.-%) erschmolzenen binären oder ternären Legierung und einer Trägerschicht,
dadurch gekennzeichnet,
daß die Trägerschicht aus einer aushärtbaren Aluminiumlegierung mit einer Mindesthärte HB ≥ 70 besteht
und daß Nutzschicht und Trägerschicht bei einem Anteil Trägerwerkstoff von 20 bis 35 % der Gesamtdicke warmgewalzt werden bei Temperaturen zwischen 350 bis 450 °C mit einem Walzgrad von mindestens 20 %, danach zwischen 450 und 550 °C Metalltemperatur für weniger als 30 Minuten lösungsgeglüht, in Wasser abgeschreckt und anschließend 2 bis 16 Stunden bei 160 bis 180 °C warmausgelagert wird.

4. Target für die Sputtertechnik, hergestellt aus einer Verbundplatte nach einem der Ansprüche 1 und 2.

5. Verfahren zur Herstellung eines Targets nach Anspruch 3,
dadurch gekennzeichnet,
daß bei einer Trägerschicht aus AlMgSi das Lösungsglühen bei einer Metalltemperatur von 485 bis 495 °C für 3 bis 10 Minuten vorgenommen wird.

## Claims

1. A composite aluminium plate which is used as a target for carrying out a coating operation by cathode sputtering and which consists of a top layer of pure aluminium (Al 99.99 % by weight) or of a binary or ternary alloy molten on a pure aluminium basis (Al ≥ 99.99 % by weight) and of a carrier layer consisting of an aluminium alloy, characterised in
that the carrier layer consists of a hardenable aluminium alloy of type AlmgsI with a minimum hardness HB > 70 and that a top layer is applied to the carrier layer by roll-cladding, which top layer comprises a fine-grain structure consisting of quasi-globulithic fine grains, whose mean grain diameter amounts to < 2 mm and whose elongation amounts to S < 2.

2. A composite aluminium plate according to claim 1, characterised in
that the top layer comprises a layer thickness of 10 to 20 mm and the carrier layer a layer thickness of 3 to 10 mm.

3. A method of producing a composite aluminium plate which is used as a target for carrying out a coating operation by cathode sputtering and which consists of a top layer of pure aluminium (Al ≥ 99.99 % by weight) or of a binary or ternary alloy molten on a pure aluminium basis (Al ≥ 99.99 % by weight), and of a carrier layer, characterised in
that the carrier layer consists of a hardenable aluminium alloy with a minimum hardness HB ≥ 70 and that the top layer and the carrier layer - with a carrier material of 20 to 35% of the total thickness - are hot-rolled at temperatures ranging between 350 and 450 °C with a degree of rolling of at least 20%, that subsequently they are solution-annealed at a metal temperature ranging between 450 and 550 °C for less than 30 minutes, quenched In water and subsequently subjected to artificial ageing for 2 to 16 hours at 160 to 180 °C.

4. A target used in sputtering technology and consisting of a composite plate according to any one of claims 1 and 2.

5. A method of producing a target according to claim 3,
characterised in
that in the case of a carrier layer consisting of AlMgsI, solution-annealing takes place at a metal temperature of 485 to 495 °C for 3 to 10 minutes.

## Revendications

1. Plaque composite en aluminium, qui est utilisable à titre de cible pour revêtement à l'aide d'une pulvérisation cathodique, cette plaque consistant en une couche d'usure en aluminium pur (Al 99,99 % en poids) ou en un alliage binaire ou ternaire fondu, à base d'aluminium pur, (Al ≥ 99,99 % en poids) et en une couche de support en alliage d'aluminium, plaque caractérisée en ce que la couche de support consiste en un alliage d'aluminium durcissable, du type AlMgSi, ayant une dureté minimale HB >70 et, sur la couche de support est plaquée par laminage une couche d'usure qui présente une structure uniforme à grain fin, en grains fins quasi-globulitiques, dont le diamètre moyen des grains est inférieur à 2 mm et dont l'étendue S est inférieure à 2.

2. Plaque composite en aluminium selon la revendication 1, caractérisée en ce que la couche d'usure présente une épaisseur de couche de 10 à 20 mm et en ce que la couche de support présente une épaisseur de couche de 3 à 10 mm.

3. Procédé de préparation d'une plaque composite en aluminium, utilisable comme cible pour le revêtement par pulvérisation cathodique, cette plaque consistant en une couche d'usure en aluminium pur, (Al ≥ à 99,99 % en poids), ou en alliage binaire ou ternaire fondu à base d'aluminium pur (Al ≥ 99,99 % en poids) et en une couche de support, procédé caractérisé en ce que la couche de support consiste en un alliage d'aluminium durcissable ayant une dureté minimale de HB supérieure ou égale à 70, et en ce que la couche d'usure et la couche de support sont laminées à chaud avec une proportion de matériau de support représentant de 20 à 25% de l'épaisseur totale, à des températures comprises entre 350 et 450°C avec un degré de laminage d'au moins 20 %, puis sont soumises à recuit de mise en solution par chauffage entre 450 et 550°C de température des métaux pendant moins de 30 minutes, elles sont brusquement refroidies dans de l'eau et maintenues ensuite à chaud durant 2 à 16 heures à 100 jusqu'à 180°C.

4. Cible pour la technique de pulvérisation, produite à partir d'une plaque composite selon une des revendications 1 et 2.

5. Procédé de préparation d'une cible selon la revendication 3, caractérisé en ce que, dans le cas d'une couche de support en AlMgSi on effectue le recuit de mise en solution à une température de métal de 485 à 495°C durant 3 à 10 minutes.
